# EUROPÄISCHE PATENTSCHRIFT

(11) **EP 0 874 388 B1**
(45) Veröffentlichungstag und Bekanntmachung des Hinweises auf die Patenterteilung: **04.10.2006**
(21) Anmeldenummer: 98103016.6
(22) Anmeldetag: 20.02.1998
(51) Int. Cl.: H01L 21/00

(54) **Anordnung zur Bearbeitung einer Substratscheibe und Verfahren zu deren Betrieb**
Arrangement and method for treatment of a disc-like substrate
Dispositif et méthode de traitement d'un substrat en forme de disque

(30) Priorität: 20.03.1997 DE 19711702
(43) Veröffentlichungstag der Anmeldung: 28.10.1998
(73) Patentinhaber: Infineon Technologies AG, 81669 München (DE)
(72) Erfinder: Kersch, Alfred, Dr., 81669 München (DE); Schafbauer, Thomas, 85521 Ottobrunn (DE)
(74) Vertreter: Kindermann, Peter

(56) Entgegenhaltungen:
- EP-A- 0 723 141
- US-A- 4 243 441
- US-A- 4 711 989
- US-A- 4 924 073
- US-A- 5 374 315
- US-A- 5 551 985
- PATENT ABSTRACTS OF JAPAN vol. 007, no. 027 (E-156), 3. Februar 1983 (1983-02-03) & JP 57 183041 A (NIPPON DENKI KK), 11. November 1982 (1982-11-11)

## Beschreibung

In der Halbleiterfertigung ist es bei vielen Prozessen wichtig, die Temperatur einer zu bearbeitenden Substratscheibe mit einer Genauigkeit unter einem Prozent zu messen und/oder zu regeln. Dieses technische Problem tritt auch außerhalb der Halbleiterfertigung bei der Bearbeitung anderer Substratscheiben auf, zum Beispiel beim Tempern und/oder Aufbringen dünner Schichten auf Substratscheiben aus Glas oder Kunststoff.

In der Halbleiterfertigung treten dabei vielfach Temperaturen weit über 1000°C auf. Das Problem stellt sich sowohl bei sogenannten RTP-Reaktoren, in denen schnelle Temperaturänderungen mit bis zu 50°C pro Sekunde vorgenommen werden, als auch in Reaktoren, in denen nur langsame Temperaturänderungen auftreten, so daß sich die Substratscheibe im thermischen Gleichgewicht mit der Umgebung befindet.

Zur Messung der Temperatur einer zu bearbeitenden Substratscheibe sind verschiedene Verfahren vorgeschlagen worden (siehe zum Beispiel Solid State Technology, December 1996, Seite 34 bis 36). In optischen Verfahren wird eine Strahlungsintensität von der oder durch die Substratscheibe gemessen. Die Genauigkeit dieser Verfahren ist dadurch eingeschränkt, daß die emittierte oder transmittierte Strahlungsintensität von den optischen Eigenschaften der Substratscheibe abhängt. Diese unterscheiden sich stark von Substratscheibe zu Substratscheibe, so daß aufwendige Eichmessungen erforderlich sind. Ferner können sich die optischen Eigenschaften durch die Bearbeitung, zum Beispiel eine Schichtabscheidung, ändern.

Desweiteren ist vorgeschlagen worden, in dem Reaktor einen Suszeptor vorzusehen. Ein Suszeptor ist ein Körper, der der Substratscheibe benachbart angeordnet wird. Die Masse des Suszeptors richtet sich nach den thermischen Erfordernissen der Anwendung. In RTP-Reaktoren, in denen schnelle Temperaturänderungen erforderlich sind, weist der Suszeptor geringe Masse und damit im allgemeinen geringe Dicke auf. In Epitaxiereaktoren oder Reaktoren zur Schichtabscheidung, in denen eine gleichförmige Temperatur erforderlich ist, weisen Suszeptoren im allgemeinen eine große Masse und damit große Dikke auf. Für den Suszeptor sind in der Literatur auch die Begriffe Wärmeschild, hot plate, hot liner und shield gebräuchlich. Zur Messung der Temperatur einer Substratscheibe wird die Temperatur des Suszeptors gemessen und es wird angenommen, daß die Temperatur des Suszeptors im wesentlichen gleich der Temperatur der Substratscheibe ist. Die Messung der Temperatur des Suszeptors erfolgt zwar durch optische Verfahren oder unter Verwendung eines Thermoelementes mit großer Genauigkeit. Die Annahme, daß die Temperatur der Substratscheibe gleich der Temperatur des Suszeptors ist, ist jedoch meist nicht zulässig.

Die Dokumente US 5374315 und EP723141 beschreiben eine Anordnung zur Bearbeitung einer Substratscheibe, bei der ein Temperatursensor zum Messung der Temperaturen am Ort des Suszeptors und am Rand des Suszeptors vorgesehen ist. Schließlich sind akustische Verfahren vorgeschlagen worden, die jedoch bisher weder bezüglich ihrer Genauigkeit noch bezüglich der Reproduzierbarkeit befriedigend sind.

Der Erfindung liegt das Problem zugrunde, eine Anordnung zur Bearbeitung einer Substratscheibe anzugeben, in der Mittel vorgesehen sind, mit der die Temperatur der Substratscheibe mit erhöhter Genauigkeit meßbar ist. Ferner soll ein Verfahren zum Betrieb einer solchen Anordnung angegeben werden.

Dieses Problem wird erfindungsgemäß gelöst durch eine Anordnung gemäß Anspruch 1. Weitere Ausgestaltungen der Erfindung sowie Betriebsverfahren für diese Anordnung gehen aus den Unteransprüchen hervor.

Die Anordnung zur Bearbeitung einer Substratscheibe ist dabei sowohl in der Halbleiterfertigung einsetzbar als auch zur Abscheidung dünner Schichten auf Substraten aus Glas oder Kunststoff. In der Halbleiterfertigung ist die Anordnung zur Bearbeitung einer Substratscheibe insbesondere als RTP-Reaktor, Epitaxiereaktor, CVD-Reaktor, Trockenätzreaktor oder plasmaunterstützter CVD-Reaktor ausführbar.

Die Anordnung zur Bearbeitung einer Substratscheibe umfaßt eine Reaktionskammer, in der ein Scheibenhalter zur Aufnahme oder Substratscheibe und ein Suszeptor vorgesehen sind. Ferner ist ein Temperatursensor vorgesehen, der zur Messung einer Temperaturdifferenz zwischen der Temperatur am Ort des Suszeptors und der Temperatur an einem Ort zwischen dem Suszeptor und dem Scheibenhalter geeignet ist. Der Temperatursensor weist dazu mindestens zwei Sensorelemente auf, von denen das eine Sensorelement am Suszeptor und das andere Sensorelement an dem Ort zwischen dem Suszeptor und dem Scheibenhalter angeordnet ist.

Zur Bestimmung der Temperatur der Substratscheibe liegt es im Rahmen der Erfindung, in dieser Anordnung die Temperaturdifferenz zwischen dem Suszeptor und einem Ort zwischen dem Suszeptor und der Substratscheibe zu messen. Unabhängig davon wird die Temperatur des Suszeptors gemessen, die mit hoher Genauigkeit meßbar ist. Aus der Temperatur des Suszeptors und der Temperaturdifferenz wird anschließend mit Hilfe einer Eichkurve die Temperatur der Substratscheibe bestimmt.

Da mit dem Temperatursensor lediglich die Temperaturdifferenz gemessen wird und diese deutlich kleiner als die Temperatur des Suszeptors ist, wird eine erhöhte Genauigkeit bei der Temperatur der Substratscheibe erreicht. Beträgt die Temperatur des Suszeptors 1000°C und die Temperaturdifferenz einige Grad Celsius, so wird auch bei einem Meßfehler am Temperatursensor im Bereich von 10 Prozent eine Genauigkeit der Temperatur der Substratscheibe unter 1 Prozent erzielt.

Als Suszeptor ist ein Körper aus Graphit, Halbleiter, Glas, Keramik oder Metall geeignet, der eine Fläche vergleichbar mit der Fläche der Substratscheibe, zum Beispiel zwischen (1 cm)² und (1 m)², aufweist und dessen Dicke zwischen 0,1 mm und einigen cm liegt.

Vorzugsweise wird als Temperatursensor ein Thermoelement mit zwei Kontaktstellen verwendet, wobei die Kontaktstellen die Sensorelemente darstellen. Die eine Kontaktstelle wird an der Oberfläche des Suszeptors angeordnet, die andere Kontaktstelle zwischen dem Suszeptor und der Substratscheibe. An dem Thermoelement wird eine Spannung abgegriffen, die proportional zu der gemessenen Temperaturdifferenz ist.

Vorzugsweise wird zur Halterung des Thermoelementes an der Oberfläche des Suszeptors eine Halterung aus thermisch isolierendem Material wie zum Beispiel Glas oder Keramik angeordnet. Die eine Kontaktstelle wird zum Beispiel an der Basis der Haltevorrichtung angeordnet, die andere Kontaktstelle wird auf der gegenüberliegenden Seite befestigt. Auf diese Weise ist die Geometrie fest vorgegeben. Gleichzeitig vermeidet die Halterung einen thermischen Kontakt zwischen dem Suszeptor und der Kontaktstelle, die zwischen dem Suszeptor und der Substratscheibe angeordnet ist. Eine solche Halterung kann zum Beispiel durch einen Hohlzylinder aus Keramik realisiert werden.

Es liegt im Rahmen der Erfindung, den Suszeptor mit dem Scheibenhalter zu verbinden. In diesem Fall ist der Abstand zwischen Suszeptor und Substratscheibe sehr gering. In dieser Ausführungsform weist der Suszeptor auf der dem Scheibenhalter zugewandten Seite eine Vertiefung auf, in der die Sensorelemente angeordnet sind. Dabei ist es vorteilhaft, die Abmessungen der Vertiefung so gering wie möglich zu halten, um die Homogenität der Temperaturverteilung im Suszeptor zu erhalten.

Vorzugsweise weist die Anordnung eine erste Heizeinrichtung und eine zweite Heizeinrichtung auf, die unabhängig voneinander ansteuerbar sind. Als Heizeinrichtung ist zum Beispiel eine Lampenheizung oder eine Widerstandsheizung geeignet. Die erste Heizeinrichtung ist dabei zur Beheizung der Substratscheibe vorgesehen, die zweite Heizeinrichtung zur Beheizung des Suszeptors. Darüber hinaus weist die Anordnung eine Regeleinheit auf, über die die erste Heizeinrichtung in Abhängigkeit der vom Temperatursensor gemessenen Temperaturdifferenz regelbar ist. Vorzugsweise wird die erste Heizeinrichtung so geregelt, daß die Temperaturdifferenz Null wird. Dadurch ist die Temperatur der Substratscheibe gleich der Temperatur des Suszeptors. Sie ist daher über Messung der Temperatur des Suszeptors genau zu bestimmen.

Gemäß einer weiteren Ausführungsform der Erfindung ist eine Kühleinrichtung vorgesehen, die mit dem Scheibenhalter thermisch verbunden ist. Als Kühleinrichtung ist zum Beispiel eine Heliumspülung zwischen Suszeptor und Substratscheibe oder eine Kühlvorrichtung des Suszeptors oder ein Andrücken mit Hilfe einer mechanischen oder elektrostatischen Kraft geeignet. Es ist eine Regeleinheit vorgesehen, über die die Kühleinrichtung regelbar ist. Diese Anordnung ist besonders vorteilhaft für derartige Reaktoren, in denen sich die Substratscheibe infolge der Bearbeitung aufheizt. Dieses ist zum Beispiel bei plasmaunterstützten Prozessen der Fall. In dieser Anordnung wird durch Messung der Temperaturdifferenz die Temperatur an der Substratscheibe überwacht, so daß die Kühlvorrichtung entsprechend der Temperatur der Substratscheibe geregelt werden kann.

Im folgenden wird die Erfindung anhand der Ausführungsbeispiele, die in den Figuren dargestellt sind, näher erläutert.
- Figur 1: zeigt eine Anordnung zur Bearbeitung einer Substratscheibe mit zwei unabhängig voneinander regelbaren Heizeinrichtungen und einer Regeleinheit.
- Figur 2: zeigt eine Anordnung zur Bearbeitung einer Substratscheibe mit einer Kühleinrichtung.

Die Darstellungen in den Figuren sind nicht maßstäblich.

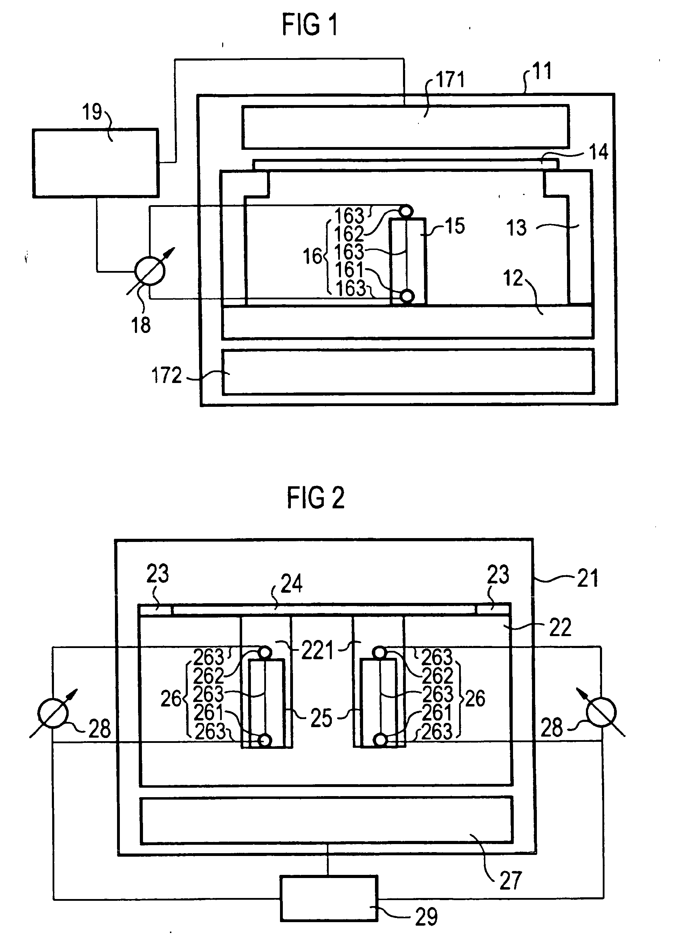

In einer Reaktionskammer 11 sind ein Suszeptor 12 aus Graphit oder SiC oder Si und ein Scheibenhalter 13 angeordnet (siehe Figur 1). Der Suszeptor 12 ist zum Beispiel scheibenförmig und weist eine Dicke von 1 mm und einen Durchmesser von einigen 10 cm auf. Der Scheibenhalter 13 besteht zum Beispiel aus Quarzglas und ist mit dem Suszeptor 12 mechanisch verbunden.

Auf dem Scheibenhalter 13 liegt eine Substratscheibe 14. Die Substratscheibe 14 weist einen Durchmesser von zum Beispiel einigen 10 cm und eine Dicke von zum Beispiel 1 mm auf. Die Substratscheibe 14 ist zum Beispiel eine monokristalline Siliziumscheibe, eine SOI-Scheibe, eine Glasscheibe oder eine Kunststoffscheibe. Der Abstand zwischen der Substratscheibe 14 und dem Suszeptor beträgt zum Beispiel 10 mm.

Auf der Oberfläche des Suszeptors 12 ist eine Halterung 15 aus thermisch isolierendem Material angeordnet. Die Halterung 15 ist zum Beispiel ein Keramikzylinder und weist eine Höhe von zum Beispiel 8 mm und einen Durchmesser von zum Beispiel 1 mm und eine Wandstärke 0.2 mm auf.

In der Reaktionskammer 11 ist ein Thermoelement 16 angeordnet, das eine erste Kontaktstelle 161, eine zweite Kontaktstelle 162 sowie Metalldrähte 163 umfaßt. Die erste Kontaktstelle 161 ist am Boden der Halterung 15 an der Oberfläche des Suszeptors 12 angeordnet. Die zweite Kontaktstelle 162 ist an der gegenüberliegenden Seite der Halterung 15 zum Beispiel in einer Verengung des Zylinders befestigt. Die Anschlüsse des Thermoelementes bildenden Metalldrähte 163 werden über Durchführungen aus der Reaktionskammer 11 hinausgeführt (nicht im einzelnen dargestellt). Der Durchmesser der Metalldrähte 163 beträgt zum Beispiel 0,1 mm. Das Thermoelement 16 besteht zum Beispiel aus Platin/Rhodium.

In der Reaktionskammer 11 ist eine erste Heizeinrichtung 171 und eine zweite Heizeinrichtung 172 vorgesehen. Die erste Heizeinrichtung 171 und die zweite Heizeinrichtung 172 sind unabhängig voneinander ansteuerbar. Es werden zum Beispiel Lampenheizungen verwendet. Die erste Heizeinrichtung 171 dient der Beheizung der Substratscheibe 14. Die zweite Heizeinrichtung 172 dient der Beheizung des Suszeptors 12.

Die Anschlüsse des Thermoelementes 16 bildenden Metalldrähte 163 sind mit einem Meßgerät 18 verbunden. An dem Meßgerät 18 fällt ein Spannungssignal ab, das abhängig ist von der Temperaturdifferenz an der ersten Kontaktstelle 161 und der zweiten Kontaktstelle 162. Dieses Spannungssignal wird auf einen Eingang einer Regeleinheit 19 gegeben. Die Regeleinheit 19 ist mit der ersten Heizeinrichtung 171 verbunden. Die Regeleinheit 19 regelt die erste Heizeinrichtung 171 so, daß das Spannungssignal, das proportional der Temperaturdifferenz, die vom Thermoelement 16 gemessen wird, ist, Null wird. Dabei wird die Erkenntnis ausgenutzt, daß wenn der Suszeptor 12 und die Substratscheibe 14 die gleiche Temperatur haben, an jedem beliebigen Punkt zwischen dem Suszeptor 12 und der Substratscheibe 14 ebenfalls diese Temperatur herrscht. Folglich kann die zweite Kontaktstelle 162 an jedem Punkt zwischen dem Suszeptor 12 und der Substratscheibe 14 angeordnet werden.

Zur Bestimmung der absoluten Temperatur der Substratscheibe 14 wird die Temperatur des Suszeptors 12 in bekannter Weise gemessen. Durch die beschriebene Regelung wird sichergestellt, daß die Temperatur der Substratscheibe 14 gleich der Temperatur des Suszeptors 12 ist.

In einem weiteren Ausführungsbeispiel umfaßt eine Anordnung zur Bearbeitung einer Substratscheibe eine Reaktionskammer 21, in der ein Suszeptor 22 und ein Scheibenhalter 23 angeordnet sind (siehe Figur 2). Der Scheibenhalter 23 ist fest mit dem Suszeptor 22 verbunden. Er bildet einen Steg am Rand des Suszeptors 22, so daß eine Substratscheibe 24 im wesentlichen auf dem Suszeptor 22 aufliegt. Der Suszeptor 22 ist zum Beispiel aus SiC beschichtetem Graphit gebildet. Er weist eine im wesentlichen zylindrische Form auf mit einem Durchmesser von zum Beispiel einigen 10 cm und einer Dicke von zum Beispiel einigen cm.

In einer Grundfläche des Suszeptors 22 sind Vertiefungen 221 angeordnet. Die Vertiefungen 221 grenzen an die Grundfläche des Suszeptors 22, auf der die Substratscheibe 24 aufliegt. Die Vertiefungen 221 weisen einen Radius von zum Beispiel 1,8 mm und eine Tiefe von zum Beispiel 4,5 mm auf.

In den Vertiefungen 221 ist jeweils eine Halterung 25 angeordnet. Diese Halterung 25 ist zum Beispiel ein Keramikzylinder und weist einen Durchmesser von zum Beispiel 1 mm, eine Wandstärke von zum Beispiel 0,2 mm und eine Höhe von zum Beispiel 4,3 mm auf.

Die Keramikzylinder stellen eine Halterung für jeweils eines der Thermoelemente 26 dar. Jedes der Thermoelemente 26 umfaßt eine erste Kontaktstelle 261, eine zweite Kontaktstelle 262 und Metalldrähte 263. Der Durchmesser der Metalldrähte 263 beträgt zum Beispiel 0,1 mm. Die Thermoelemente 26 bestehen zum Beispiel aus Platin/Rhodium. Die erste Kontaktstelle 261 ist dabei am Boden der Vertiefung 221 an der Oberfläche des Suszeptors 22 angeordnet. Die zweite Kontaktstelle 262 ist auf der gegenüberliegenden Seite der Halterung 25 befestigt. Zwei der Metalldrähte 263 dienen als Anschlüsse des Thermoelementes und sind über Durchführungen (nicht dargestellt) mit einem Meßgerät 28 verbunden. An dem Meßgerät 28 wird ein Spannungssignal erzeugt, das proportional zur Temperaturdifferenz am Ort der ersten Kontaktstelle 261 und der zweiten Kontaktstelle 262 ist.

In der Reaktionskammer 21 ist darüber hinaus eine Kühleinrichtung 27 angeordnet. Die Kühleinrichtung 27 ist thermisch mit dem Suszeptor 22 verbunden. Damit ist sie auch mit der Substratscheibe 24 thermisch verbunden, die innerhalb des Scheibenhalters 23 auf der Oberfläche des Suszeptors 22 aufliegt. Die Kühleinrichtung 27 besteht zum Beispiel aus einer Platte die selbst gekühlt wird. Alternativ ist die Kühleinrichtung durch eine Heliumspülung zwischen Suszeptor und Substratscheibe 24 oder durch Andrücken der Substratscheibe mit Hilfe einer mechanischen oder elektrischen Kraft realisiert.

Es ist eine Regeleinrichtung 29 vorgesehen, die in Abhängigkeit der von den Meßgeräten 28 gemessenen Temperaturdifferenzen die Kühleinrichtung 27 regelt. In vielen Prozessen ist es vorteilhaft, die Regelung so vorzunehmen, daß die Temperaturdifferenz an keinem Ort einen vorgegebenen Wert uberschreitet. Insbesondere bei plasmaunterstützten Prozessen wird auf diese Weise eine unzulässige Aufheizung der Substratscheibe 24 durch Ionenbeschuß vermieden.

Die Erfindung ist nicht auf die beiden beschriebenen Ausführungsbeispiele beschränkt. Insbesondere ist es möglich, in dem anhand von Figur 1 beschriebenen Ausführungsbeispiel einen Suszeptor zu verwenden, der analog Figur 2 ausgeführt ist. Ferner können Heizeinrichtungen verwendet werden, die nicht unabhängig voneinander steuerbar sind. In diesem Fall entfällt die Regelung. Am Meßgerät 18 wird dann eine Temperaturdifferenz gemessen, aus der sich zusammen mit der Temperatur des Suszeptors anhand einer Eichkurve die Temperatur der Substratscheibe 14 ermitteln läßt. Ferner kann in dem anhand von Figur 1 erläuterten Ausführungsbeispiel anstelle der Heizeinrichtung eine Kühleinrichtung vorgesehen werden.

Auch an dem anhand von Figur 2 erläuterten Ausführungsbeispiel sind analoge Varianten möglich, insbesondere die Verwendung von unabhängig voneinander steuerbaren Heizeinrichtungen und einer Regelung, wie anhand von Figur 1 erläutert, oder die Verwendung eines Suszeptors analog dem anhand von Figur 1 beschriebenen oder das Vorsehen nur einer Vertiefung, falls Temperaturinhomogenitäten über die Fläche der Substratscheibe 24 keine Rolle spielen. Ferner kann die Regelung entfallen.

## Patentansprüche

1. Anordnung zur Bearbeitung einer Substratscheibe,
- bei der in einer Reaktionskammer (11) ein Scheibenhalter (13) zur Aufnahme einer Substratscheibe (14) und ein Suszeptor (12) vorgesehen sind, **dadurch gekennzeichnet dass**
- bei der ein Temperatursensor (16) zur Messung der Differenz der Temperaturen am Ort des Suszeptors und an einem Ort zwischen dem Suszeptor (12) und der Substratscheibe (14) vorgesehen ist, der zwei Sensorelemente (161, 162) aufweist, wobei das eine Sensorelement (161) am Suszeptor (12) und das andere Sensorelement (162) an dem Ort zwischen dem Suszeptor (12) und der Substratscheibe (14) angeordnet ist.

2. Anordnung nach Anspruch 1,
bei der als Temperatursensor (16) ein Thermoelement mit zwei Kontaktstellen (161, 162) verwendet wird, wobei die Kontaktstellen (161, 162) die Sensorelemente darstellen.

3. Anordnung nach Anspruch 2,
bei dem an der Oberfläche des Suszeptors (12) zur Aufnahme des Thermoelementes (16) eine Halterung (15) aus thermisch isolierendem Material angeordnet ist.

4. Anordnung nach einem der Ansprüche 1 bis 3,
- bei der der Suszeptor (22) mit dem Scheibenhalter (23) verbunden ist,
- bei der in dem Suszeptor (22) auf der dem Scheibenhalter zugewandten Seite eine Vertiefung (221) vorgesehen ist, in der die Sensorelemente (261, 262) angeordnet sind.

5. Anordnung nach einem der Ansprüche 1 bis 4,
- bei der eine erste Heizeinrichtung (171) zur Beheizung der Substratscheibe (14) und eine zweite Heizeinrichtung (172) zur Beheizung des Suszeptors (12) vorgesehen sind, wobei die erste Heizeinrichtung (171) und die zweite Heizeinrichtung (172) unabhängig voneinander ansteuerbar sind,
- bei der eine Regeleinheit (19) vorgesehen ist, über die die erste Heizeinrichtung (171) in Abhängigkeit der vom Temperatursensor (60) gemessenen Temperaturdifferenz regelbar ist.

6. Anordnung nach einem der Ansprüche 1 bis 4,
- bei der eine Kühleinrichtung (27) vorgesehen ist, die mit dem Scheibenhalter (23) thermisch verbunden ist,
- bei der eine Regeleinheit (29) vorgesehen ist, über die die Kuhleinrichtung (27) regelbar ist.

7. Anordnung nach einem der Ansprüche 1 bis 6,
- bei der mehrere Temperatursensoren (26) mit jeweils zwei Sensorelementen (261, 262) vorgesehen sind, wobei das eine der Sensorelemente (261) jeweils an unterschiedlichen Orten am Suszeptor (22) und das andere Sensorelement (262) zwischen dem Suszeptor (22) und der Substratscheibe (24) angeordnet ist.

8. Verfahren zum Messen der Temperatur einer Substratscheibe in einer Anordnung nach einem der Ansprüche 1 bis 7,
- bei dem die Temperatur des Suszeptors (12) gemessen wird,
- bei dem aus der Temperatur des Suszeptors und der am Temperatursensor gemessene Temperaturdifferenz unter Verwendung einer Eichkurve die Temperatur der Substratscheibe (14) bestimmt wird.

9. Verfahren zum Betrieb einer Anordnung nach Anspruch 5, bei dem die erste Heizeinrichtung (171) von der Regeleinheit (19) so geregelt wird, daß die gemessene Temperaturdifferenz im wesentlichen Null ist.

10. Verfahren zum Betrieb einer Anordnung nach Anspruch 6,
- bei dem die Temperatur des Suszeptors (22) gemessen wird,
- bei dem die Temperatur der Substratscheibe aus der Temperatur des Suszeptors (22) und der am Temperatursensor (26) gemessenen Temperaturdifferenz bestimmt wird,
- bei dem die Kühleinrichtung (27) von der Regeleinheit (29) in Abhängigkeit der Temperatur der Substratscheibe (24) geregelt wird.

## Claims

1. Arrangement for processing a substrate wafer,
- in which a wafer holder (13), intended to hold a substrate wafer (14), and a susceptor (12) are provided in a reaction chamber (11), **characterized in that**
- a temperature sensor (16) for measuring the difference between the temperatures at the site of the susceptor and at a site between the susceptor (12) and the substrate wafer (14) is provided, which has two sensor elements (161, 162), one of the sensor elements (161) being arranged on the susceptor (12) and the other sensor element (162) being arranged at the site between the susceptor (12) and the substrate wafer (14).

2. Arrangement according to Claim 1, in which a thermocouple having two junctions (161, 162) is used as the temperature sensor (16), the junctions (161, 162) representing the sensor elements.

3. Arrangement according to Claim 2, in which a frame (15) made of thermally insulating material is arranged on the surface of the susceptor (12) in order to hold the thermocouple (16).

4. Arrangement according to one of Claims 1 to 3,
- in which the susceptor (22) is connected to the wafer holder (23),
- in which the susceptor (22) is provided with an indentation (221), which is on the side facing the wafer holder and in which the sensor elements (261, 262) are arranged.

5. Arrangement according to one of Claims 1 to 4,
- in which a first heating device (171), for heating the substrate wafer (14), and a second heating device (172), for heating the susceptor (12), are provided, it being possible for the first heating device (171) and the second heating device (172) to be driven independently of one another,
- in which a control unit (19) is provided, using which the first heating device (171) can be controlled as a function of the temperature difference measured by the temperature sensor (60).

6. Arrangement according to one of Claims 1 to 4,
- in which a cooling device (27) is provided, which is thermally connected to the wafer holder (23),
- in which a control unit (29) is provided, using which the cooling device (27) can be controlled.

7. Arrangement according to one of Claims 1 to 6,
- in which a plurality of temperature sensors (26) are provided, each with two sensor elements (261, 262), one of the sensor elements (261) being in each case arranged at different sites on the susceptor (22), and the other sensor element (262) being arranged between the susceptor (22) and the substrate wafer (24).

8. Method for measuring the temperature of a substrate wafer in an arrangement according to one of Claims 1 to 7,
- in which the temperature of the susceptor (12) is measured,
- in which the temperature of the substrate wafer (14) is determined, using a calibration curve, from the temperature of the susceptor and the temperature difference measured with the temperature sensor.

9. Method for operating an arrangement according to Claim 5, in which the first heating device (171) is controlled by the control unit (19) in such a way that the measured temperature difference is substantially zero.

10. Method for operating an arrangement according to Claim 6,
- in which the temperature of the susceptor (22) is measured,
- in which the temperature of the substrate wafer is determined from the temperature of the susceptor (22) and the temperature difference measured with the temperature sensor (26),
- in which the cooling device (27) is controlled by the control unit (29) as a function of the temperature of the substrate wafer (24).

## Revendications

1. Dispositif pour traiter une tranche de substrat dans lequel un suscepteur (12) et un porte-tranche (13) pour recevoir une tranche de substrat (14) sont prévus dans une chambre de réacteur (11),
**caractérisé en ce qu'**un capteur de température (16) est prévu pour mesurer la différence des températures à l'endroit du suscepteur et à un endroit entre le suscepteur (12) et la tranche de substrat (14), le capteur comportant deux éléments capteurs (161, 162) dont l'un des éléments capteurs (161) se trouve sur le suscepteur (12) et l'autre élément capteur (162) à l'endroit entre le suscepteur (12) et la tranche de substrat (14).

2. Dispositif selon la revendication 1, dans lequel le capteur de température (16) utilisé est un thermocouple muni de deux points de contact (161, 162), les points de contact (161, 162) représentant les éléments capteurs.

3. Dispositif selon la revendication 2, dans lequel un support (15) en un matériau thermiquement isolant est placé à la surface du suscepteur (12) pour recevoir le thermocouple (16).

4. Dispositif selon l'une des revendications 1 à 3, dans lequel
- le suscepteur (22) est relié au porte-tranche (23),
- une cavité (221) dans laquelle se trouvent les éléments capteurs (261, 262) est prévue dans le suscepteur (22) sur le côté tourné vers le porte-tranche (221).

5. Dispositif selon l'une des revendications 1 à 4, dans lequel sont prévus
- un premier dispositif de chauffage (171) pour chauffer la tranche de substrat (14) et un deuxième dispositif de chauffage (172) pour chauffer le suscepteur (12), le premier dispositif de chauffage (171) et le deuxième dispositif de chauffage (172) pouvant être commandés indépendamment l'un de l'autre,
- une unité de réglage (19) qui permet de régler le premier dispositif de chauffage (171) en fonction de la différence de température mesurée par le capteur de température (60).

6. Dispositif selon l'une des revendications 1 à 4, dans lequel sont prévus
- un dispositif de refroidissement (27) en liaison thermique avec le porte-tranche (23),
- une unité de réglage (29) qui permet de régler le dispositif de refroidissement (27).

7. Dispositif selon l'une des revendications 1 à 6, dans lequel sont prévus
- plusieurs capteurs de température (26) dont chacun a plusieurs éléments capteurs (261, 262), l'un des éléments capteurs (261) se trouve respectivement à différents endroits sur le suscepteur (22) et l'autre élément capteur (262) entre le suscepteur (22) et la tranche de substrat (24).

8. Procédé pour mesurer la température d'une tranche de substrat dans un dispositif d'après l'une des revendications 1 à 7, d'après lequel
- on mesure la température du suscepteur (12),
- on détermine en utilisant une courbe d'étalonnage la température de la tranche de substrat (14) à partir de la température du suscepteur et de la différence de température mesurée sur le capteur de température.

9. Procédé pour exploiter un dispositif selon la revendication 5, d'après lequel le premier dispositif de chauffage (171) est réglé par l'unité de réglage (19) de telle manière que la différence de température mesurée est pratiquement nulle.

10. Procédé pour exploiter un dispositif selon la revendication 6, d'après lequel
- on mesure la température du suscepteur (22),
- on détermine la température de la tranche de substrat à partir de la température du suscepteur (22) et de la différence de température mesurée sur le capteur de température (26),
- l'unité de réglage (29) règle le dispositif de refroidissement (27) en fonction de la température de la tranche de substrat (24).
